# FASCICULE DE BREVET EUROPEEN

(11) **EP 1 226 609 B1**
(45) Date de publication et mention de la délivrance du brevet: **20.12.2006**
(21) Numéro de dépôt: 00974601.7
(22) Date de dépôt: 30.10.2000
(51) Int. Cl.: H01L 31/0203, H01L 25/16

(54) **BOITIER SEMI-CONDUCTEUR OPTIQUE ET PROCEDE DE FABRICATION D'UN TEL BOITIER**
GEHÄUSE FÜR OPTISCHE HALBLEITERELEMENTE UND HERSTELLUNGSVERFAHREN SOLCHER GEHÄUSE
OPTICAL SEMICONDUCTOR HOUSING AND METHOD FOR MAKING SAME

(30) Priorité: 04.11.1999 FR 9913776
(43) Date de publication de la demande: 31.07.2002
(73) Titulaire: STMicroelectronics S.A., 92120 Montrouge (FR)
(72) Inventeur: VITTU, Julien, F-38160 Saint Marcellin (FR)
(74) Mandataire: Casalonga, Axel
(86) Numéro de dépôt international: PCT/FR2000/003020
(87) Numéro de publication internationale: WO 2001/033635

(56) Documents cités:
- EP-A- 0 790 652
- EP-A- 0 807 976
- WO-A-99/50904
- JP-A- 11 164 209
- JP-A- 11 191 865

## Description

La présente invention concerne un procédé de fabrication d'un boîtier semi-conducteur optique et un boîtier semi-conducteur optique.

Les documents JP-A-11191865 et JP-A-11164209 décrivent des boîtiers semi-conducteurs optiques dans lesquels une plaque support présentant un passage traversant porte d'un côté un composant semi-conducteur optique présentant un capteur optique situé dans ce passage et d'un autre côté une plaque transparente.

Par ailleurs, le document EP-A-807976 décrit un boîtier semi-conducteur optique dans lequel des composants sont montés de part et d'autre d'une plaque support.

Le but de la présente invention est de proposer une structure de boîtier semi-conducteur optique comprenant plusieurs composants semi-conducteurs et un procédé de fabrication d'un tel boîtier de telle sorte que ce boîtier présente un encombrement réduit et soit susceptible d'être utilisé immédiatement pour de préférence délivrer des données d'images à partir des données d'un composant semi-conducteur à capteur optique.

La présente invention a tout d'abord pour objet un boîtier semi-conducteur optique comprenant une plaque support de connexion électrique qui présente un passage traversant et qui comprend des lignes internes et/ou externes constituant un réseau de connexions électriques présentant des zones et/ou plots de connexions électriques ; un composant semi-conducteur dont une face avant comprend un capteur optique et qui est fixée sur une face arrière de ladite plaque de telle sorte que son capteur optique soit situé en face dudit passage traversant ; des moyens de connexion électrique dudit composant optique à ladite plaque support comprenant des billes de connexion électrique disposées entre la face avant dudit composant optique et la face arrière de ladite plaque support ; des moyens d'encapsulation dudit composant sur la face arrière de ladite plaque support comprenant un matériau d'enrobage enveloppant lesdits billes et s'étendant entre la face avant dudit composant et la face arrière de ladite plaque support, un couvercle au moins en partie transparent fixé sur une face avant de ladite plaque support et recouvrant ledit passage traversant ; et des moyens de connexion électrique extérieure disposés sur une partie découverte de ladite plaque support.

Selon l'invention, un tel boîtier comprend en outre un second composant semi-conducteur, tel qu'un microprocesseur, dont une face avant est fixée à une face arrière dudit composant optique, des moyens de connexion électrique de ce second composant à ladite plaque support comprenant des fils électriques et des moyens d'encapsulation desdits composants empilés sur la face arrière de ladite plaque support comprenant un matériau d'enrobage desdits composants et desdits fils de connexion électrique.

Selon l'invention, lesdits moyens de connexion électrique extérieure comprennent de préférence des zones métalliques réalisées en surface sur ladite plaque support.

Selon l'invention, lesdits moyens de connexion électrique extérieure peuvent avantageusement comprendre des billes de connexion placées sur lesdits zones métalliques.

Selon l'invention, lesdits moyens de connexion électrique extérieure peuvent avantageusement comprendre des colonnes de connexion.

Selon l'invention, le bord périphérique dudit couvercle (20) est de préférence engagé dans un évidement annulaire entourant ledit passage traversant.

La présente invention a tout d'abord pour objet un procédé de fabrication d'un boîtier semi-conducteur optique, consistant à réaliser un passage traversant au travers d'une plaque support de connexion électrique qui comprend des lignes internes et/ou externes constituant un réseau de connexions électriques présentant des zones et/ou plots de connexions électriques ; à fixer une face avant d'un composant semi-conducteur sur une face arrière de ladite plaque support, ce composant comprenant sur sa face avant un capteur optique, de telle sorte que son capteur optique soit situé en face dudit passage traversant, et à relier électriquement ledit composant optique à ladite plaque support, par l'intermédiaire de billes de connexion électrique disposées entre la face avant dudit composant optique et la face arrière de ladite plaque support ; à encapsuler lesdites billes de connexion électrique dans un matériau d'enrobage remplissant l'espace annulaire entre ledit composant optique et ladite plaque support ; et à fixer un couvercle au moins en partie transparent sur une face avant de ladite plaque support de telle sorte que ce couvercle recouvre ledit passage traversant.

Selon l'invention, le procédé consiste en outre à fixer un second composant sur la face arrière dudit composant optique, à relier électriquement ledit second composant à ladite plaque support par des fils de connexion électrique et à encapsuler lesdits composants et lesdits fils de connexion électrique sur la face arrière de ladite plaque support dans un matériau d'enrobage.

La présente invention sera mieux comprise à l'étude d'un boîtier semi-conducteur optique et de son procédé de fabrication, décrits à titre d'exemples non limitatifs et illustrés par le dessin sur lequel :
- la figure 1 représente une première étape de fabrication d'un boîtier selon la présente invention, en vue de côté ;
- la figure 2 représente une seconde étape de fabrication dudit boîtier ;
- la figure 3 représente une troisième étape de fabrication dudit boîtier ;
- la figure 4 représente une vue de face dudit boîtier ;
- la figure 5 représente une quatrième étape de fabrication d'une autre variante d'exécution dudit boîtier ;
- la figure 6 représente une quatrième étape de fabrication d'une autre variante d'exécution dudit boîtier ;
- la figure 7 représente une quatrième étape de fabrication d'une autre variante d'exécution dudit boîtier ;
- la figure 8 représente une troisième étape de fabrication d'une autre variante d'exécution dudit boîtier ;
- la figure 9 représente une quatrième étape de fabrication du boîtier de la figure 8 ;
- et la figure 10 représente une cinquième étape de fabrication du boîtier de la figure 8.

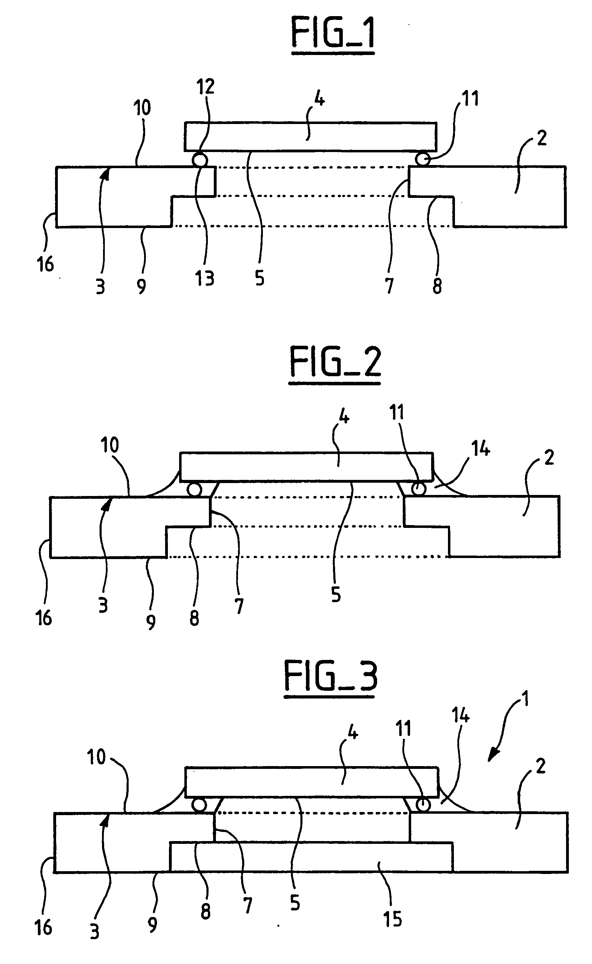

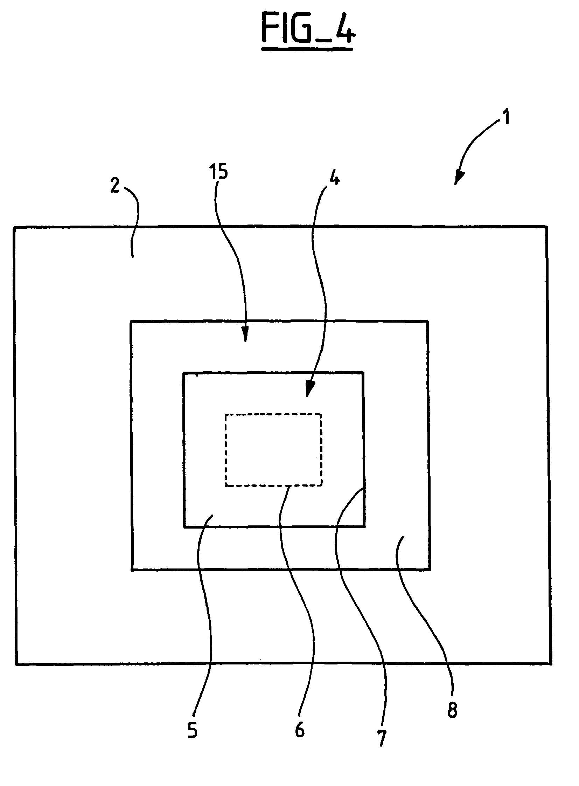

En référence aux figures 1 à 4, on va tout d'abord décrire les différentes étapes de fabrication d'un boîtier semi-conducteur optique repéré d'une manière générale par la référence 1 et représenté terminé sur les figures 3 et 4.

En se reportant à la figure 1, on voit qu'on dispose, de façon préfabriquée, d'un substrat 2 constitué par une plaque support qui présente des lignes internes et/ou externes constituant un réseau 3 de connexions électriques et d'un composant semi-conducteur 4 qui présente, dans la partie centrale de sa face avant, un capteur optique 6.

La plaque support 2 présente un passage traversant 7 et un évidement ou lamage annulaire 8 réalisé autour du passage traversant 7 et dans sa face avant 9.

Dans une première étape de fabrication, on fixe et on connecte électriquement la face avant 5 du composant optique 4 à la face arrière 10 de la plaque support 2 par l'intermédiaire d'une multiplicité de billes métalliques 11 réparties qui sont interposées entre d'une part des plots métalliques de connexion électrique 12 réalisés en surface sur la face avant 5 du composant optique 4, entre sa partie centrale 6 et son bord périphérique et d'autre part des plots métalliques de connexion 13 réalisés en surface sur la face arrière 10 de la plaque support 2, à l'extérieur de son passage traversant 7, le composant optique 4 étant disposé de telle sorte que son capteur optique 6 soit placé en face du passage traversant 7 de la plaque support 2.

Dans une seconde étape de fabrication représentée sur la figure 2, on encapsule le composant 4 sur la face arrière 10 de la plaque support 2 en remplissant l'espace annulaire séparant la face avant 5 du composant optique 4 et la face arrière 10 de la plaque support 2 d'un matériau d'enrobage et d'étanchéité 14 dans lequel se trouvent noyées les billes de connexion 11.

Dans une troisième étape de fabrication représentée sur la figure 3, on installe un couvercle avant plat 15 en un matériau transparent dans le passage traversant 7 de la plaque support 2 de telle sorte que son bord péripériphérique soit engagé dans son évidement annulaire 8, le bord périphérique de ce couvercle 15 étant fixé dans cet évidement 8 par l'intermédiaire d'une couche de colle.

La plaque support 2 est préalablement munie sur son champ périphérique de zones métalliques en surface 16 reliées à son réseau de connexion électrique 3, ces zones métalliques 16 constituant des moyens de connexion électrique extérieure du composant optique 4 au travers de la plaque support 2.

On obtient ainsi, comme le montrent les figures 3 et 4, un boîtier semi-conducteur optique 1 étanche, équipé d'un composant semi-conducteur optique 4 susceptible d'être connecté à un circuit extérieur grâce aux zones métalliques 16.

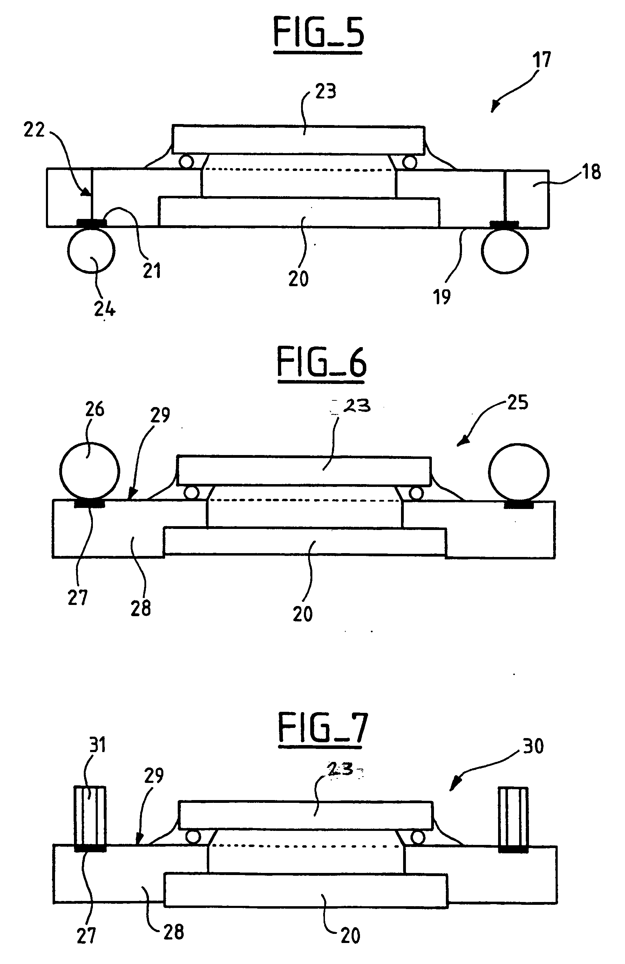

En se reportant à la figure 5, on voit qu'on a représenté un boîtier 17 qui se différencie du boîtier 1 de la figure 3 uniquement par le fait que sa plaque support 18 présente sur sa face avant 19, autour de son couvercle avant 20, des zones métalliques de connexion électrique 21 reliées à son réseau de connexion électrique 22 de son composant optique 23, sur lesquelles on dépose, dans une quatrième étape de fabrication, des billes métalliques 24 de connexion électrique extérieure.

En se reportant à la figure 6, on voit que le boîtier 25 représenté constitue une variante d'exécution du boîtier 17 de la figure 5, qui s'en différencie par le fait que ses billes métalliques 26 de connexion électrique extérieure sont placées sur des plots métalliques 27 de sa plaque support 28, qui sont prévues sur la face arrière 29 de cette dernière, autour et à distance de son composant optique 23.

En se reportant à la figure 7, on voit que le boîtier 30 représenté se différencie du boîtier 25 de la figure 6 uniquement par le fait que les billes métalliques 26 sont remplacées par des colonnes 31 de connexion électrique extérieure qui sont reliées électriquement aux plots métalliques 27.

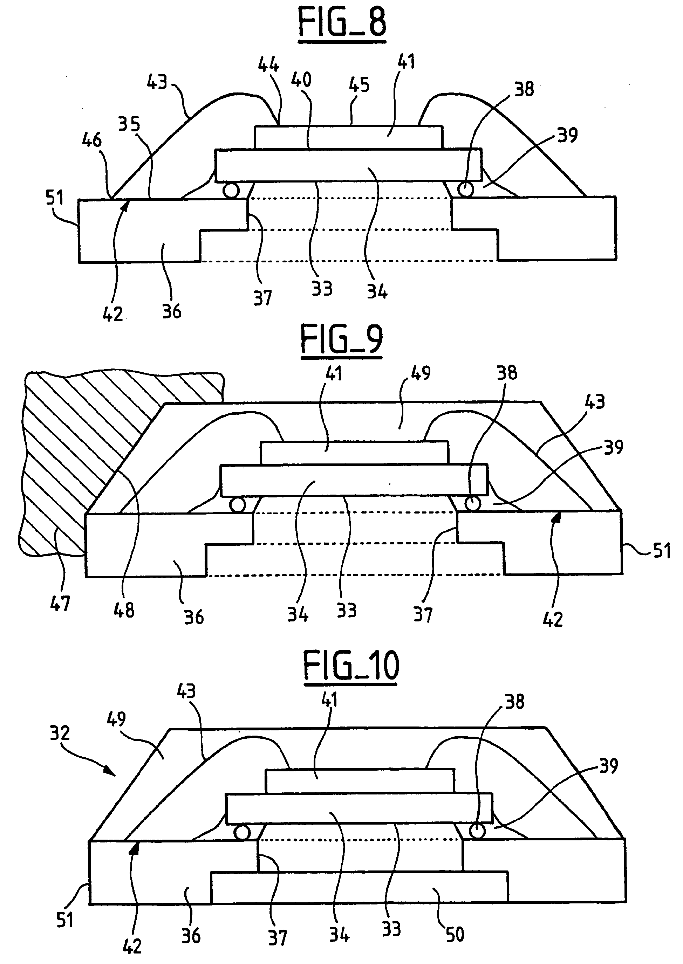

En se reportant aux figures 8 à 10, on va maintenant décrire les différentes étapes de fabrication d'un autre boîtier semi-conducteur optique repéré d'une manière générale par la référence 32 et représenté terminé sur la figure 10.

Dans une première étape de fabrication identique à celle exposée précédemment en référence à la figure 1, on fixe et on connecte électriquement la face avant 33 d'un composant optique 34 sur la face arrière 35 d'une plaque support 36 présentant un passage central 37 par l'intermédiaire de billes de connexion 38.

Puis, dans une seconde étape de fabrication identique à celle exposée précédemment en référence à la figure 2, on remplit l'espace annulaire contenant les billes 38 par un matériau d'enrobage 39.

Dans une troisième étape de fabrication représentée sur la figure 8, on fixe sur la face arrière 40 du composant optique 34 un composant semi-conducteur 41, tel qu'un microprocesseur ou coprocesseur, par l'intermédiaire d'une couche de colle ou de tout autre moyen.

Puis, on relie électriquement le composant 41 au réseau de connexions électriques 42 de la plaque support 36 en fixant l'une des extrémités de fils de connexion électrique 43 à des plots métalliques 44 formés en surface sur la face arrière 45 du composant 41 et en fixant l'autre extrémité des fils de connexion électrique 43 à des plots métalliques 46 du réseau 42, formés en surface sur la face arrière 35 de la plaque support 36.

Dans une troisième étape de fabrication représentée sur la figure 9, on installe l'ensemble tel que monté de la figure 8 dans un moule 47 qui présente une cavité 48 enveloppant à distance les composants 34 et 41 et les fils de connexion électrique 43.

Ensuite, on injecte un matériau d'enrobage dans la cavité 48 de manière à constituer un bloc 49 en arrière de la face arrière 35 de la plaque support 36 dans lequel se trouvent noyés les composants 34 et 41 et les fils de connexion électrique 43. Puis, on procède au démoulage.

Dans une quatrième étape de fabrication représentée sur la figure 10, on installe un couvercle 50 dans le passage 37 comme décrit précédemment en référence à la figure 3.

La plaque support 36 du boîtier 32 est munie, comme celle de la figure 3, de zones métalliques 51 de connexion électrique extérieure.

On obtient ainsi, comme le montre la figure 10, un boîtier semi-conducteur optique 32 complet, équipé d'un composant semi-conducteur optique 19 et d'un coprocesseur, reliés électriquement de façon adaptée par l'intermédiaire du réseau de connexion électrique 42 de la plaque support 1 et susceptibles d'être connectés à un circuit extérieur grâce aux zones métalliques 51.

Bien entendu, les zones métalliques de connexion extérieure 51 pourraient être remplacées par des billes métalliques ou des colonnes de connexion électrique extérieure comme proposées en référence aux figures 5 à 7.

La présente invention ne se limite pas aux exemples ci-dessus décrits. Bien d'autres variantes sont possibles sans sortir du cadre défini par les revendications annexées.

## Revendications

1. Boîtier semi-conducteur optique, comprend une plaque support (2) de connexion électrique qui présente un passage traversant (7) et qui comprend des lignes internes et/ou externes constituant un réseau (3) de connexions électriques présentant des zones et/ou plots de connexions électriques, un composant semi-conducteur (4) dont une face avant (5) comprend un capteur optique (6) et qui est fixée sur une face arrière (10) de ladite plaque de telle sorte que son capteur optique soit situé en face dudit passage traversant, des moyens de connexion électrique (11) dudit composant optique à ladite plaque support comprenant des billes de connexion électrique disposées entre la face avant dudit composant optique et la face arrière de ladite plaque support, des moyens d'encapsulation (14) dudit composant sur la face arrière de ladite plaque support comprenant un matériau d'enrobage (14).enveloppant lesdits billes et s'étendant entre la face avant dudit composant et la face arrière de ladite plaque support, un couvercle (15) au moins en partie transparent fixé sur une face avant de ladite plaque support et recouvrant ledit passage traversant (7), et des moyens de connexion électrique extérieure (16) disposés sur une partie découverte de ladite plaque support, **caractérisé par le fait qu'**il comprend en outre un second composant semi-conducteur (41), tel qu'un microprocesseur, dont une face avant est fixée à une face arrière dudit composant optique (34), des moyens de connexion électrique (43) de ce second composant à ladite plaque support comprenant des fils électriques (43) et des moyens d'encapsulation (49) desdits composants empilés sur la face arrière de ladite plaque support comprenant un matériau d'enrobage desdits composants et desdits fils de connexion électrique.

2. Boîtier selon la revendication 1, **caractérisé par le fait que** lesdits moyens de connexion électrique extérieure comprennent des zones métalliques (16) réalisées en surface sur ladite plaque support.

3. Boîtier selon la revendication 2, **caractérisé par le fait que** lesdits moyens de connexion électrique extérieure comprennent des billes de connexion (26) placées sur lesdits zones métalliques.

4. Boîtier selon la revendication 2, **caractérisé par le fait que** lesdits moyens de connexion électrique extérieure comprennent des colonnes de connexion (31).

5. Boîtier selon l'une quelconque des revendications précédentes, **caractérisé par le fait que** le bord périphérique dudit couvercle (20) est engagé dans un évidement annulaire (8) entourant ledit passage traversant (7).

6. Procédé de fabrication d'un boîtier semi-conducteur optique, consistant à réaliser un passage traversant (7) au travers d'une plaque support (2) de connexion électrique qui comprend des lignes internes et/ou externes constituant un réseau (3) de connexions électriques présentant des zones et/ou plots de connexions électriques (16) ; à fixer une face avant d'un composant semi-conducteur (4) sur une face arrière de ladite plaque support, ce composant comprenant sur sa face avant un capteur optique (6), de telle sorte que son capteur optique soit situé en face dudit passage traversant, et à relier électriquement ledit composant optique à ladite plaque support, par l'intermédiaire de billes de connexion électrique disposées entre la face avant dudit composant optique et la face arrière dé ladite plaque support ; à encapsuler lesdites billes de connexion électrique dans un matériau d'enrobage (39) remplissant l'espace annulaire entre ledit composant optique et ladite plaque support ; et à fixer un couvercle (20) au moins en partie transparent sur une face avant de ladite plaque support (2) de telle sorte que ce couvercle recouvre ledit passage traversant (7) ; **caractérisé par le fait qu'**il consiste à fixer un second composant (41) sur la face arrière dudit composant optique, à relier électriquement ledit second composant à ladite plaque support par des fils de connexion électrique (43) et à encapsuler lesdits composants et lesdits fils de connexion électrique sur la face arrière de ladite plaque support dans un matériau d'enrobage (49).

## Claims

1. Optical semiconductor package, comprising an electrical connection support plate (2) which has a through-passage (7) and which comprises internal and/or external lines forming a network (3) of electrical connections having electrical connection areas and/or pads, a semiconductor component (4), a front face (5) of which comprises an optical sensor (6) which is fixed on a rear face (10) of said plate so that its optical sensor is placed opposite said through-passage, means (11) of electrically connecting said optical component to said support plate comprising electrical connection balls located between the front face of said optical component and the rear face of said support plate, means (14) of encapsulating said component on the rear face of said support plate comprising an encapsulation material (14) covering said balls and extending between the front face of said component and the rear face of said support plate, a lid (15) at least partly transparent, fixed on a front face of said support plate and covering said through-passage (7), and external electrical connection means (16) located on an exposed part of said support plate, **characterized in that** it also comprises a second semiconductor component (41), such as a microprocessor, a front face of which is fixed to a rear face of said optical component (34), means (43) of electrically connecting this second component to said support plate comprising electrical wires (43) and means (49) of encapsulating said components stacked on the rear face of said support plate comprising a material for encapsulating said components and said electrical connection wires.

2. Package according to Claim 1, **characterized in that** said external electrical connection means comprise metallic areas (16) made on the surface on said support plate.

3. Package according to Claim 2, **characterized in that** said external electrical connection means comprise connection balls (26) placed on said metallic areas.

4. Package according to Claim 2, **characterized in that** said external electrical connection means comprise connection columns (31).

5. Package according to any one of the preceding claims, **characterized in that** the peripheral edge of said lid (20) is engaged in an annular hollow (8) surrounding said through-passage (7).

6. Process for fabricating an optical semiconductor package, consisting in creating a through-passage (7) through an electrical connection support plate (2) which comprises internal and/or external lines forming a network (3) of electrical connections having electrical connection areas and/or pads (16); in fixing a front face of a semiconductor component (4) on a rear face of said support plate, this component comprising on its front face an optical sensor (6), such that its optical sensor is placed opposite said through-passage, and electrically connecting said optical component to said support plate, via electrical connection balls located between the front face of said optical component and the rear face of said support plate; in encapsulating said electrical connection balls in an encapsulation material (39) filling the annular space between said optical component and said support plate; and fixing a lid (20) at least partly transparent, on a front face of said support plate (2) such that this lid covers said through-passage (7); **characterized in that** it consists in fixing a second component (41) on the rear face of said optical component, in electrically linking said second component to said support plate by electrical connection wires (43) and in encapsulating said components and said electrical connection wires on the rear face of said support plate in an encapsulation material (49).

## Patentansprüche

1. Gehäuse für optische Halbleiterelemente, das aufweist:
eine Trägerplatte (2) mit elektrischen Anschlüssen, die einen Durchgang (7) und interne und/oder externe Leitungen aufweist, die ein Netz (3) aus elektrischen Verbindungen bilden, das elektrische Anschlußzonen und/oder -kontakte aufweist,
ein Halbleiterelement (4), dessen vordere Fläche (5) einen optischen Sensor (6) aufweist und das auf eine solche Weise an einer hinteren Fläche (10) der Platte befestigt ist, daß sein optischer Sensor gegenüber dem Durchgang angeordnet ist,
Anschlußeinrichtungen (11) zum elektrischen Anschließen des optischen Elements an der Trägerplatte, die elektrische Anschlußkügelchen aufweisen, die zwischen der vorderen Fläche des optischen Elements und der hinteren Fläche der Trägerplatte angeordnet sind,
Einkapselungseinrichtungen (14) zum Einkapseln des Elements an der hinteren Fläche der Trägerplatte, die ein Vergußmaterial (14) aufweisen, das die Kügelchen einhüllt und sich zwischen der vorderen Fläche des Elements und der hinteren Fläche der Trägerplatte erstreckt,
einen zumindest teilweise transparenten Deckel (15), der an einer vorderen Fläche der Trägerplatte befestigt ist und den Durchgang (7) bedeckt, und
externe elektrische Anschlußeinrichtungen (16), die an einem unbedeckten Teil der Trägerplatte angeordnet sind,
**dadurch gekennzeichnet, daß** es ferner aufweist:
ein zweites Halbleiterelement (41), beispielsweise einen Mikroprozessor, dessen vordere Fläche an einer hinteren Fläche des optischen Elements (34) befestigt ist,
Anschlußeinrichtungen (43) zum elektrischen Anschließen dieses zweiten Elements an der Trägerplatte, die elektrische Drähte (43) aufweisen, und
Einkapselungseinrichtungen (49) zum Einkapseln der an der hinteren Fläche der Trägerplatte gestapelten Elemente, die ein Vergußmaterial der Elemente und der elektrischen Anschlußdrähte aufweisen.

2. Gehäuse nach Anspruch 1, **dadurch gekennzeichnet, daß** die externen elektrischen Anschlußeinrichtungen Metallzonen (16) aufweisen, die an der Oberfläche der Trägerplatte gebildet sind.

3. Gehäuse nach Anspruch 2, **dadurch gekennzeichnet, daß** die externen elektrischen Anschlußeinrichtungen Anschlußkügelchen (26) aufweisen, die an den Metallzonen angeordnet sind.

4. Gehäuse nach Anspruch 2, **dadurch gekennzeichnet, daß** die externen elektrischen Anschlußeinrichtungen Anschlußsäulen (31) aufweisen.

5. Gehäuse nach einem der vorstehenden Ansprüche, **dadurch gekennzeichnet, daß** der Umfangsrand des Deckels (20) mit einer ringförmigen Aussparung (8) im Eingriff ist, die den Durchgang (7) umgibt.

6. Verfahren zur Herstellung eines Gehäuses für optische Halbleiterelemente, aufweisend:
Herstellen eines Durchgangs (7) durch eine Trägerplatte (2) mit elektrischen Anschlüssen, die interne und/oder externe Leitungen aufweist, die ein Netz (3) aus elektrischen Verbindungen bilden, das elektrische Anschlußzonen und/oder - kontakte (16) aufweist;
Befestigen einer vorderen Fläche eines Halbleiterelements (4), das an seiner vorderen Fläche einen optischen Sensor (6) aufweist, auf eine solche Weise an einer hinteren Fläche der Trägerplatte, daß sein optischer Sensor gegenüber dem Durchgang angeordnet ist, und elektrisches Anschließen des optischen Elements an der Trägerplatte über elektrische Anschlußkügelchen, die zwischen der vorderen Fläche des optischen Elements und der hinteren Fläche der Trägerplatte angeordnet sind;
Einkapseln der elektrischen Anschlußkügelchen in einem Vergußmaterial (39), das den ringförmigen Raum zwischen dem optischen Element und der Trägerplatte füllt; und
Befestigen eines zumindest teilweise transparenten Deckels (20) an einer vorderen Fläche der Trägerplatte (2) auf eine solche Weise, daß dieser Deckel den Durchgang (7) bedeckt;
**gekennzeichnet durch**
Befestigen eines zweiten Elements (41) an der hinteren Fläche des optischen Elements,
elektrisches Anschließen des zweiten Elements über elektrische Anschlußdrähte (43) an der Trägerplatte und
Einkapseln der Elemente und der elektrischen Anschlußdrähte an der hinteren Fläche der Trägerplatte in einem Vergußmaterial (49).
